(19)

**Europäisches Patentamt**

**European Patent Office**

**Office européen des brevets**

(11) **EP 2 836 455 B1**

(12) **EUROPÄISCHE PATENTSCHRIFT**

(45) Veröffentlichungstag und Bekanntmachung des Hinweises auf die Patenterteilung:
**18.10.2017 Patentblatt 2017/42**

(21) Anmeldenummer: **13707863.0**

(22) Anmeldetag: **05.03.2013**

(51) Int Cl.:
**B81B 3/00** *(2006.01)*      **B81C 1/00** *(2006.01)*

(86) Internationale Anmeldenummer:
**PCT/EP2013/054418**

(87) Internationale Veröffentlichungsnummer:
**WO 2013/152899 (17.10.2013 Gazette 2013/42)**

(54) **MEMBRANANORDNUNG FÜR EINEN MIKRO-ELEKTROMECHANISCHEN MESSUMFORMER**

MEMBRANE ARRANGEMENT FOR A MICRO-ELECTROMECHANICAL MEASURING TRANSDUCER

ENSEMBLE MEMBRANE POUR UN TRANSDUCTEUR DE MESURE MICRO-ÉLECTROMÉCANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.04.2012 DE 102012205921**

(43) Veröffentlichungstag der Anmeldung:
**18.02.2015 Patentblatt 2015/08**

(73) Patentinhaber: **Robert Bosch GmbH**
**70442 Stuttgart (DE)**

(72) Erfinder:
• **DALEY, Mike**
  **Canonsburg, Pennsylvania PA 15317 (US)**
• **SCHEBEN, Rolf**
  **70499 Stuttgart (DE)**
• **SCHELLING, Christoph**
  **70597 Stuttgart (DE)**

(56) Entgegenhaltungen:
JP-A- 2008 259 061      US-A1- 2006 233 401
US-A1- 2007 284 682      US-A1- 2007 287 215
US-B1- 6 402 968      US-B1- 6 441 451

• CHEN J ET AL: "On the single-chip condenser miniature microphone using DRIE and backside etching techniques", SENSORS AND ACTUATORS A, ELSEVIER SEQUOIA S.A., LAUSANNE, CH, Bd. 103, Nr. 1-2, 15. Januar 2003 (2003-01-15), Seiten 42-47, XP004400378, ISSN: 0924-4247, DOI: 10.1016/S0924-4247(02)00326-6
• CHEN JING ET AL: "Dynamic characteristics of novel single-chip fabricated corrugated diaphragms for micro-acoustic devices", SOLID-STATE AND INTEGRATED-CIRCUIT TECHNOLOGY, 2001. PROCEEDINGS. 6TH INTERNATIONAL CONFERENCE ON OCT. 22-25, 2001, PISCATAWAY, NJ, USA,IEEE, Bd. 2, 22. Oktober 2001 (2001-10-22), Seiten 757-760, XP010576079, ISBN: 978-0-7803-6520-9

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**EP 2 836 455 B1**

## Beschreibung

Die Erfindung betrifft eine Membrananordnung für einen mikro-elektromechanischen Messumformer und ein Verfahren zum Herstellen einer Membrananordnung für einen mikro-elektromechanischen Messumformer, insbesondere für mikro-elektromechanische Drucksensoren, Mikrofone und Lautsprecher.

Stand der Technik

Miniaturisierte Drucksensoren und akustische Signalumformer wie Mikrofone oder Lautsprecher werden für verschiedene Anwendungen eingesetzt, beispielsweise für akustische Bauteile in tragbaren Telekommunikationsgeräten. Die Sensoren und Aktoren können dabei aus mikro-elektromechanischen Strukturen (MEMS, "microelectromechanical systems") hergestellt werden.

Derartige Sensoren und Signalumformer können auf dem kapazitiven Wirkprinzip beruhen, das heißt, zwei in einer vorbestimmten Geometrie zueinander angeordnete Membranelemente werden mit Spannung beaufschlagt. Durch Änderung der Spannung können Bewegungen der Membranen relativ zueinander induziert werden. Alternativ können von außen induzierte Membranbewegungen zu erfassbaren Änderungen der Kapazität und damit der anliegenden Spannung führen.

Die Druckschrift DE 102 47 847 A1 beispielsweise offenbart ein Verfahren zum Herstellen einer Membran für ein MEMS-Bauelement mit einer Gegenelektrode auf einem Substrat. Die Druckschrift DE 10 2006 055 147 B4 offenbart ein Verfahren zum Herstellen einer Schallwandlerstruktur mit einer schwingungsfähigen Membran über einer Gegenelektrode auf einem Substrat. Die Druckschrift EP 2 071 871 A1 offenbart eine Membran für ein MEMS-Bauteil mit einem korrugierten Randbereich zum Abbau von mechanischen Spannungen in der Membran. Die US 6,035,714 A beschreibt einen mikro-elektromechanischen kapazitiven Beschleunigungssensor mit einem Silizium-Wafer, welcher als Nachweismasse zwischen einer ersten Elektrode und einer zweiten Elektrode angeordnet ist. Weitere Beispiele für kapazitive Sensorstrukturen mit einer in Bewegungen versetzbaren Nachweismasse sind in der US 6,441,451 B1, der JP 2008 259061 A und Chen J. et al: "On the single-chip condenser miniatur microphone using DRIE and backside etching techniques" (SENSORS AND ACTUATORS A, ELSEVIER SEQUOIA S.A., LAUSANNE, CH, Bd. 103, Nr. 1-2, 15. Januar 2003 (2003-01-15), Seiten 42-47, XP004400378) offenbart.

Es besteht ein Bedarf an Membrananordnungen, insbesondere für mikro-elektromechanische akustische Signalumformer, mit welchen die Empfindlichkeit der Signalaufnahme verbessert und der Bauraumbedarf entsprechend verringert werden kann.

Offenbarung der Erfindung

Die vorliegende Erfindung schafft eine mikro-elektromechanische Membrananordnung mit den Merkmalen des Anspruchs 1 und ein mikro-elektromechanisches Bauelement mit den Merkmalen des Anspruchs 9.

Vorteile der Erfindung

Es ist eine Idee der vorliegenden Erfindung, mindestens eine Membran einer mikro-elektromechanischen Membrananordnung, die auf einem kapazitiven Wirkprinzip basiert, mit Vertiefungen bzw. einer vorbestimmten Welligkeit auszugestalten, so dass kapazitive vertikale Bereiche der Membrananordnung entstehen, deren Membranabschnitte bei einer vertikalen Bewegung der Membranen lateral zueinander verschoben werden. Dadurch verursacht eine vertikale Membranbewegung eine linear mit der Membranauslenkung verlaufende Kapazitätsänderung der vertikalen Bereiche.

Ein erheblicher Vorteil dieser Membrananordnung besteht darin, dass auch bei kleinen vertikalen Membranauslenkungen eine große Kapazitätsänderung verursacht wird bzw. bei geringfügigen Kapazitätsänderungen durch kleine Spannungsänderungen zwischen den Membranen hohe Membranauslenkungen resultieren. Insgesamt ergibt sich für solche Membrananordnungen ein erheblich größerer Signalhub bei kleinen Messwertänderungen, das heißt eine größere Empfindlichkeit der Membranordnung.

Derartigen Membrananordnungen mit hoher Empfindlichkeit können mit entsprechend geringeren Abmessungen ausgestaltet werden, da die effektiv wirksame kapazitive Fläche erhöht ist. Dadurch ergeben sich in vorteilhafter Weise ein geringerer Bauraumbedarf und eine kostengünstigere Bauweise.

Bei einem Einsatz derartiger Membrananordnungen in Aktoren können höhere Beschleunigungswerte für die Membranen bei geringerer Spannung erzielt werden. Bei Sensoren können aus denselben Gründen größere Signalhübe erzielt werden.

Ein weiterer positiver Effekt der erfindungsgemäßen Membrananordnungen ist die verbesserte mechanische Stabilität und Steifigkeit, die sich durch die Wahl der Geometrie der Vertiefungen bzw. der Welligkeit einstellen lässt.

Bei der erfindungsgemäßen Membrananordnung weist die Membranschicht eine Vielzahl von über den ersten Vertiefungen ausgebildeten zweiten Vertiefungen auf. Dadurch ist ein sich mit einer vertikalen Bewegung der Membranschicht linear ändernder Überlappbereich der Elektrodenschicht mit der Membranschicht geschaffen.

Außerdem sind die zweiten Vertiefungen dazu ausgelegt, bei einer Auslenkung der Membranschicht senkrecht zu der Oberfläche des Substrats berührungslos in die ersten Vertiefungen ineinander zu greifen. Dadurch ist eine laterale Sensor- bzw. Aktorkapazität mit hoher Beschleunigung auch aus der Nulllage heraus geschaffen.

Zusätzlich umfasst die Membrananordnung eine zweite elektrisch leitfähige Elektrodenschicht, welche über der Membranschicht angeordnet und von dieser um den ersten Abstandswert beabstandet ist, und welche eine Vielzahl von über den ersten Vertiefungen ausgebildeten dritten Vertiefungen aufweist. Über diese Doppelmembranstruktur wird ein größerer Signalhub bzw. eine größere Beschleunigung der Membranschicht erzielt.

Gemäß einer Ausführungsform der erfindungsgemäßen Membrananordnung können die zweiten Vertiefungen Außenwände mit einer vertikalen Erstreckung aufweisen, die größer als der erste Abstandswert ist. Alternativ können die zweiten Vertiefungen Außenwände mit einer vertikalen Erstreckung aufweisen, die genauso groß wie der erste Abstandswert ist. Auf diese Weise kann entweder eine besonders kompakte und flache Membrangeometrie ausgestaltet werden oder eine Membrangeometrie ohne parasitäre Kapazitäten in der Nulllage der auslenkbaren Membranschicht.

Gemäß einer weiteren Ausführungsform der erfindungsgemäßen Membrananordnung können die Außenwände der ersten Vertiefungen von den Außenwänden der zweiten Vertiefungen parallel zu der Oberfläche des Substrats einen zweiten Abstandswert aufweisen. Über die Einstellung des zweiten Abstandswerts kann in vorteilhafter Weise die Empfindlichkeit der Membrananordnung eingestellt werden.

Gemäß einer weiteren Ausführungsform der erfindungsgemäßen Membrananordnung können die Außenwände der zweiten Vertiefungen von den Außenwänden der dritten Vertiefungen parallel zu der Oberfläche des Substrats den zweiten Abstandswert aufweisen. Dadurch wird eine symmetrische Doppelmembranstruktur geschaffen, die hohe Signalhübe bzw. große Beschleunigungswerte der Membranschicht erzielt.

Gemäß einer weiteren Ausführungsform der erfindungsgemäßen Membrananordnung können die erste Elektrodenschicht und das Substrat eine Vielzahl von ersten Druckausgleichslöchern aufweisen, welche in den ersten Vertiefungen ausgebildet sind. Diese Druckausgleichslöcher dienen dem Entweichen der in den Zwischenräumen zwischen der Elektrodenschicht und der Membranschicht befindlichen Luft bei einer Bewegung der Membranschicht, so dass der Strömungswiderstand durch die Druckausgleichslöcher vorteilhafterweise geringer als längs der Zwischenräume ist.

Gemäß einer weiteren Ausführungsform wird die erste Elektrodenschicht direkt vom Substrat gebildet.

Gemäß einer weiteren Ausführungsform der erfindungsgemäßen Membrananordnung kann die zweite Elektrodenschicht eine Vielzahl von dritten Druckausgleichslöchern aufweisen, welche in den dritten Vertiefungen und/oder zwischen den dritten Vertiefungen ausgebildet sind. Diese Druckausgleichslöcher dienen dem Entweichen der in den Zwischenräumen zwischen der zweiten Elektrodenschicht und der Membranschicht befindlichen Luft bei einer Bewegung der Membranschicht, so dass der Strömungswiderstand durch die Druckausgleichslöcher vorteilhafterweise geringer als längs der Zwischenräume ist.

Weitere Merkmale und Vorteile von Ausführungsformen der Erfindung ergeben sich aus der nachfolgenden Beschreibung mit Bezug auf die beigefügten Zeichnungen.

Kurze Beschreibung der Zeichnungen

Die beschriebenen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt. Richtungsangaben wie "links", "rechts", "oben", "unten", "über", "unter", "neben" oder dergleichen sind in der folgenden Beschreibung lediglich zu erläuternden Zwecken verwendet und stellen keine Beschränkung der Allgemeinheit dar.

Es zeigen:

Fig. 1 eine schematische Darstellung einer mikro-elektromechanischen Membrananordnung in Querschnittsansicht gemäß einer Ausführungsform der vorliegenden Erfindung;

Fig. 2 eine schematische Darstellung einer mikro-elektromechanischen Membrananordnung in Querschnittsansicht gemäß einer weiteren Ausführungsform der vorliegenden Erfindung;

Fig. 3          eine schematische Darstellung einer mikro-elektromechanischen Membrananordnung in Querschnittsansicht, welche nicht unter die Erfindung fällt;

Fig. 4          eine schematische Darstellung einer mikro-elektromechanischen Membrananordnung in Querschnittsansicht, welche nicht unter die Erfindung fällt;

Fig. 5          eine schematische Darstellung einer mikro-elektromechanischen Membrananordnung in Querschnittsansicht, welche nicht unter die Erfindung fällt;

Fig. 6          eine schematische Darstellung einer mikro-elektromechanischen Membrananordnung in Draufsicht gemäß einer weiteren Ausführungsform der vorliegenden Erfindung;

Fig. 7          eine schematische Darstellung einer mikro-elektromechanischen Membrananordnung in Draufsicht gemäß einer weiteren Ausführungsform der vorliegenden Erfindung;

Fig. 8          eine schematische Darstellung einer mikro-elektromechanischen Membrananordnung in Draufsicht gemäß einer weiteren Ausführungsform der vorliegenden Erfindung;

Fig. 9 bis 13    schematische Darstellungen von Prozessschritten eines Verfahrens zum Herstellen einer mikro-elektromechanischen Membrananordnung, welches nicht unter die Erfindung fällt; und

Fig. 14 bis 18   schematische Darstellungen von Prozessschritten eines Verfahrens zum Herstellen einer mikro-elektromechanischen Membrananordnung, welches nicht unter die Erfindung fällt.

Die gezeigten mikro-elektromechanischen Membrananordnungen (MEMS-Membrananordnungen) können jeweils für mikro-elektromechanische Bauelemente (MEMS-Bauelemente) wie beispielsweise Signalumformer bzw. Messumformer, MEMS-Sensoren, MEMS-Aktoren oder membranbasierte Inertialsensoren eingesetzt werden. Derartige MEMS-Bauelemente können beispielsweise Drucksensoren, Mikrofone, Lautsprecher oder sonstige akustische Energieumwandler umfassen.

Vertiefungen im Sinne der vorliegenden Erfindung sind alle senkrecht oder im Wesentlichen senkrecht zu einer Oberfläche einer im Wesentlichen planaren Komponente ausgebildeten Formabweichungen der Komponente. Insbesondere können Vertiefungen im Sinne der vorliegenden Erfindung Nuten, Korrugationen, Sicken, Rillen, Riefen, Mulden oder ähnliche winklige oder wellige Ausbuchtungen der im Wesentlichen planaren Komponente sein. Die Vertiefungen können dabei entlang der Oberfläche der im Wesentlichen planaren Komponente in regelmäßigen oder unregelmäßigen Abständen voneinander angeordnet sein. Die Vertiefungen können eine Vielzahl von senkrecht zu der lateralen Ausdehnung der im Wesentlichen planaren Komponenten verlaufenden Vertiefungsabschnitten aufweisen.

Zwei im Wesentlichen planare Komponenten, die planparallel übereinander und in Richtung ihrer lateralen Ausdehnungen beabstandet voneinander angeordnet sind, können dabei Vertiefungen aufweisen, die sich im Wesentlichen derart decken, dass die einzelnen Vertiefungen bei einer Bewegung der im Wesentlichen planaren Komponenten aufeinander zu ineinander greifen, ohne dass sich die beiden Komponenten berühren. Mit anderen Worten können die Vertiefungen der einen Komponente eine ähnliche räumliche Ausgestaltung wie die der anderen Komponente aufweisen, wobei die Vertiefungen der einen Komponente geringere räumliche Abmessungen aufweisen als die Vertiefungen der anderen Komponente. Auf diese Weise kann eine Verzahnung der Komponenten ineinander erzielt werden, so dass eine Relativbewegung der beiden im Wesentlichen planparallen Komponenten senkrecht zu ihren lateralen Ausdehnungen möglich ist, ohne dass sich die Komponenten berühren.

Auf ähnliche Weise können drei im Wesentlichen planare Komponenten planparallel zueinander angeordnet werden, so dass ein berührungsloses Ineinandergreifen der in der Mitte befindlichen Komponente mit jeweils einer der außen angeordneten Komponenten bei einer Auf- und Abbewegung relativ zu den äußeren Komponenten möglich wird.

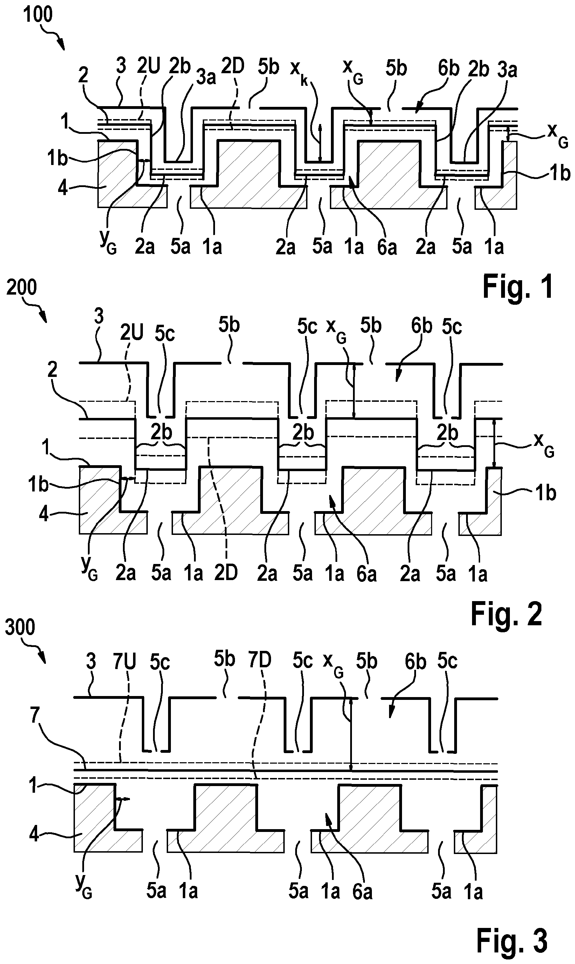

Fig. 1 zeigt eine schematische Darstellung einer mikro-elektromechanischen Membrananordnung 100 in Querschnittsansicht. Die Membrananordnung 100 umfasst ein Substrat 4 mit Ausnehmungen, eine erste elektrisch leitfähige Elektrodenschicht 1, welche auf einer Oberfläche des Substrats 4 aufgebracht ist. Die erste Elektrodenschicht 1 kann beispielsweise eine einkristalline Siliziumschicht sein. Alternativ kann es auch möglich sein, die erste Elektrodenschicht 1 mit einer Metallisierungsschicht auszugestalten. In einer Ausführungsvariante kann die erste Elektrodenschicht 1 eine erste funktionale Schicht auf einem Silizium-auf-Isolator-Wafer 4 ("silicon on insulator", SOI-Wafer) sein. Die erste Elektrodenschicht 1 kann erste Vertiefungen 1a aufweisen, die im Wesentlichen übereinstimmend mit den Ausnehmungen in dem Substrat 4 ausgebildet sind. Im Beispiel der Fig. 1 sind die Ausnehmungen als quaderförmige Nuten mit im Wesentlichen senkrecht zu der Oberfläche des Substrats 4 stehenden Außenwänden ausgebildet, die sich über eine vorbestimmte, beispielsweise konstante Tiefe in das Substrat 4 hinein erstrecken.

Über der ersten Elektrodenschicht 1 kann eine in einer Richtung senkrecht zu der Oberfläche des Substrats 4 auslenkbare und elektrisch leitfähige Membranschicht 2 angeordnet sein. In einer Ausführungsvariante kann die Membranschicht 2 beispielsweise aus Polysilizium bestehen. Die Membranschicht 2 kann an Aufhängungspunkten außerhalb des in Fig. 1 dargestellten Schnittbereichs an dem Substrat über einen oder mehrere Aufhängungsstege aufgehängt sein, so dass die Membranschicht 2 schwingend über der ersten Elektrodenschicht 1 gelagert ist. Von der ersten Elektrodenschicht 1 ist die Membranschicht 2 um einen ersten (vertikalen) Abstandswert $x_G$ beabstandet. Der Abstandswert $x_G$ kann beispielsweise zwischen $0,1\mu$ und $10\mu$ liegen.

Die Membranschicht 2 weist dabei zweite Vertiefungen 2a auf, die im Wesentlichen über den ersten Vertiefungen 1a angeordnet sind, in einer Weise, dass die äußeren Abmessungen der zweiten Vertiefungen 2a geringfügig kleiner als die entsprechenden Abmessungen der ersten Vertiefungen 1a sind. Dadurch können die zweiten Vertiefungen 2a berührungslos in die ersten Vertiefungen 1a eingreifen. Von den Außenwänden 1b der ersten Vertiefungen 1a sind die Außenwände 2b der zweiten Vertiefungen 2a um einen Abstandswert $y_G$ beabstandet.

Durch die vertikale Bewegung der Membranschicht 2, beispielsweise bei einer Aktuierung der Membranschicht 2 kann die Membranschicht 2 im Wesentlichen senkrecht zu der Oberfläche des Substrats 4 auf- und abbewegt werden, wie in Fig. 1 über die gestrichelten Linien angedeutet. Beispielsweise kann die maximale Auslenkung nach oben in einer Lage 2U der Membranschicht 2 resultieren, während die maximale Auslenkung nach unten in einer Lage 2D der Membranschicht 2 resultieren kann.

Die Membrananordnung 100 weist weiterhin eine zweite elektrisch leitfähige Elektrodenschicht 3 auf, welche über der Membranschicht 2 angeordnet und von dieser um den ersten Abstandswert $x_G$ beabstandet ist. Die zweite elektrisch leitfähige Elektrodenschicht 3 kann beispielsweise aus Polysilizium oder einer Metallisierungslage hergestellt werden. Die zweite Elektrodenschicht 3 kann eine Vielzahl von über den ersten Vertiefungen 1a ausgebildeten dritten Vertiefungen 3a aufweisen. Für die dritten Vertiefungen 3a kann im Verhältnis zu den zweiten Vertiefungen 2a im Wesentlichen das gleiche gelten wie für das Verhältnis der zweiten Vertiefungen 2a zu den ersten Vertiefungen 1a. Die Membrananordnung 100 ist mit anderen Worten so strukturiert, dass sich die geometrischen Strukturen der Vertiefungen 1a, 2a und 3a so miteinander decken, dass eine Bewegung der Membranschicht 2 im Zwischenraum zwischen den Elektrodenschichten 1 und 3 derart ermöglicht wird, dass die zweiten Vertiefungen 2a berührungslos mit den ersten und dritten Vertiefungen 1a bzw. 3a verzahnen.

Die erste Elektrodenschicht 1 sowie das Substrat 4 können über erste Durchgangslöcher bzw. Druckausgleichslöcher 5a verfügen, die am Boden der ersten Vertiefungen 1a ausgebildet sind. Über die ersten Druckausgleichslöcher 5a wird ein Austausch von Luft oder einem anderen die ersten Zwischenräume 6a zwischen der ersten Elektrodenschicht 1 und der Membranschicht 2 ausfüllenden Medium ermöglicht. Vorzugsweise sind die Ausmaße der ersten Druckausgleichslöcher 5a derart gestaltet, dass der Strömungswiderstand der Luft oder des anderen Mediums durch die ersten Druckausgleichslöcher 5a kleiner ist als längs des ersten Zwischenraums 6a. Dadurch entweicht die Luft oder das andere Medium vorzugsweise durch die ersten Druckausgleichslöcher 5a.

Die zweite Elektrodenschicht 3 kann über zweite Durchgangslöcher bzw. Druckausgleichslöcher 5b verfügen, die zwischen den dritten Vertiefungen 3a ausgebildet sind. Über die zweiten Druckausgleichslöcher 5b wird ein Austausch von Luft oder einem anderen die zweiten Zwischenräume 6b zwischen der zweiten Elektrodenschicht 3 und der Membranschicht 2 ausfüllenden Medium ermöglicht. Vorzugsweise sind die Ausmaße der zweiten Druckausgleichslöcher 5b derart gestaltet, dass der Strömungswiderstand der Luft oder des anderen Mediums durch die zweiten Druckausgleichslöcher 5b kleiner ist als längs des zweiten Zwischenraums 6b. Dadurch entweicht die Luft oder das andere Medium vorzugsweise durch die zweiten Druckausgleichslöcher 5b.

Die Anzahl der ersten und zweiten Druckausgleichslöcher 5a bzw. 5b ist dabei prinzipiell nicht begrenzt. Insbesondere kann es vorgesehen sein, nicht in jeder ersten Vertiefung 1a bzw. nicht zwischen jedem Paar von dritten Vertiefungen 3a Druckausgleichslöcher 5a bzw. 5b auszubilden.

Die Außenwände 2b der zweiten Vertiefungen 2a können von den Außenwänden der dritten Vertiefungen 3a parallel zu der Oberfläche des Substrats 4 denselben zweiten Abstandswert $y_G$ aufweisen wie die Außenwände 2b der zweiten Vertiefungen 2a von den Außenwänden 1b der ersten Vertiefungen 1a.

Fig. 2 zeigt eine schematische Darstellung einer weiteren mikro-elektromechanischen Membrananordnung 200 in Querschnittsansicht. Die mikro-elektromechanische Membrananordnung 200 unterscheidet sich von der mikro-elektromechanischen Membrananordnung 100 im Wesentlichen nur darin, dass der vertikale Abstand $x_G$ zwischen Membranschicht 2 und ersten und zweiten Elektrodenschichten 1 bzw. 3 genauso groß gewählt wird wie die vertikale Erstreckung $x_k$ der Vertiefungen 2a und 1a bzw. 3a. Außerdem können in der mikro-elektromechanischen Membrananordnung 200 auch am Boden dritten Vertiefungen 3a Durchgangslöcher bzw. Druckausgleichslöcher 5c ausgebildet sein. Mit der Membrananordnung 200 können die parasitären Kapazitätsanteile vorteilhafterweise gegenüber der Membrananordnung 100 auf Kosten des Bauraumbedarfs verringert werden.

Fig. 3 zeigt eine schematische Darstellung einer weiteren mikro-elektromechanischen Membrananordnung 300 in Querschnittsansicht, welche nicht unter die Erfindung fällt. Die mikro-elektromechanische Membrananordnung 300 unterscheidet sich von der mikro-elektromechanischen Membrananordnung 200 im Wesentlichen nur darin, dass statt einer Membranschicht 2 mit Vertiefungen 2 eine planparallel zur Oberfläche des Substrats 4 ausgebildete Membranschicht 7 zwischen den ersten und zweiten Elektrodenschichten 1 und 3 verwendet wird, die zwischen einer maximalen Auslenkung 7U nach oben und einer maximalen Auslenkung 7U nach unten gegenüber den Elektrodenschichten 1 und 3 beweglich ist.

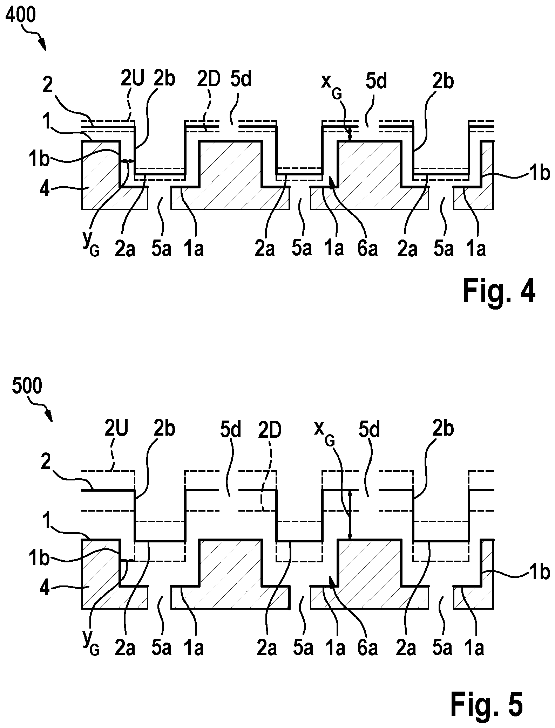

Fig. 4 zeigt eine schematische Darstellung einer weiteren mikro-elektromechanischen Membrananordnung 400 in Querschnittsansicht, welche nicht unter die Erfindung fällt. Die mikro-elektromechanische Membrananordnung 400 unterscheidet sich von der mikro-elektromechanischen Membrananordnung 100 im Wesentlichen nur darin, dass keine zweite Elektrodenschicht 3 vorgesehen ist. Stattdessen weist die Membranschicht 2 Durchgangslöcher bzw. Druckausgleichslöcher 5d zwischen den Vertiefungen 2a der Membranschicht 2 auf.

Fig. 5 zeigt eine schematische Darstellung einer weiteren mikro-elektromechanischen Membrananordnung 500 in Querschnittsansicht, welche nicht unter die Erfindung fällt. Die mikro-elektromechanische Membrananordnung 500 unterscheidet sich von der mikro-elektromechanischen Membrananordnung 400 im Wesentlichen nur darin, dass der vertikale Abstand $x_G$ zwischen Membranschicht 2 und der ersten Elektrodenschicht 1 genauso groß gewählt wird wie die vertikale Erstreckung $x_k$ der Vertiefungen 2a und 1a. Auf diese Weise kann wie oben erwähnt eine Verringerung der parasitären Kapazitätsanteile auf Kosten des Bauraumbedarfs erfolgen.

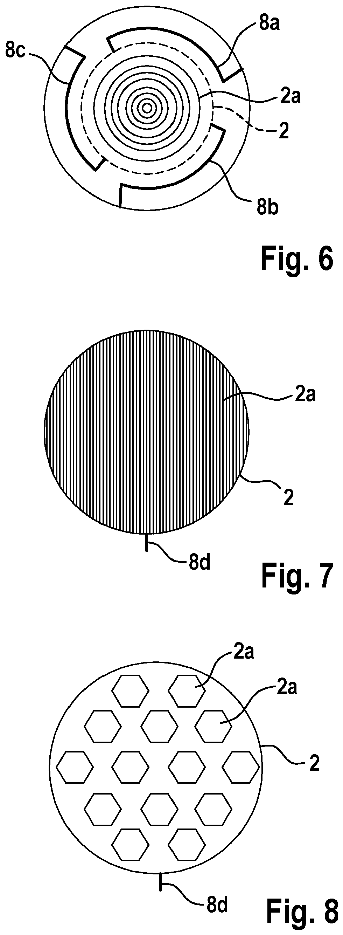

Die Fig. 6, 7 und 8 zeigen schematische Darstellungen von mikro-elektromechanischen Membrananordnungen in Draufsicht. Die in den Fig. 6, 7 und 8 dargestellten Membrananordnungen können den Membrananordnungen 100, 200, 300, 400, 500 der Fig. 1 bis 5 entsprechen. In Fig. 6 ist die Membranschicht 2 kreisrund und die Vertiefungen 2a sind als kreisrunde und konzentrisch angeordnete Rillen bzw. Sicken ausgebildet. Die Membranschicht 2 kann über Aufhängungsstege 8a, 8b, 8c am Substrat aufgehängt sein. Beispielhaft beträgt die Anzahl der Aufhängungsstege in Fig. 6 drei, wobei jedoch jede andere Anzahl an Aufhängungsstegen ebenso möglich ist.

In Fig. 7 ist die Membranschicht 2 mit Längsrillen bzw. Längssicken als Vertiefungen 2a ausgebildet. Die Aufhängung der Membranschicht 2 erfolgt dabei über einen Aufhängungssteg 8d. In Fig. 8 ist die Membranschicht 2 mit polygonalen Mulden als Vertiefungen 2a ausgebildet, so dass sich beispielsweise eine eierschachtelartige Oberflächenstruktur der Membranschicht 2 ergibt. Selbstverständlich können auch andere polygonale oder abgerundete Strukturen für die Mulden in Fig. 8 gewählt werden. Beispielhaft beträgt die Anzahl der Aufhängungsstege 8d in Fig. 7 und 8 eins, wobei jedoch jede andere Anzahl an Aufhängungsstegen 8d ebenso möglich ist.

Mit den vorliegenden Membrananordnungen 100, 200, 300, 400, 500, wie in den Fig. 1 bis 8 dargestellt, ist bei aktuierten Membranen, zum Beispiel bei einem Lautsprecher, bei einem linearen Out-of-Plane-Antrieb oder bei einem Ultraschallgeber, eine hohe Beschleunigung der Membran schon aus der Ruhelage heraus möglich. Dies führt vorteilhafterweise zu hohen Schalldrücken und somit zu einem effizienten Betrieb eines die Membranordnung verwendenden MEMS-Aktors.

Grundsätzlich gilt, dass der Schalldruck p proportional zu der Beschleunigung a der Membran ist. Die Beschleunigung a der Membran ergibt sich aus ihrer Bewegungsgleichung. Wird zur Beschleunigung eine elektrostatische Kraft zwischen einer planaren Membranschicht und einer planparallel dazu angeordneten Elektrodenschichten eingesetzt, und wird weiterhin angenommen, dass die Membranschicht näherungsweise frei beweglich ist, ergibt sich für die Beschleunigung a:

$$a = \frac{d^2 x}{dt^2} = \frac{\varepsilon_0 \cdot \varepsilon_r \cdot A \cdot U^2}{2 \cdot m \cdot (x - x_G)^2},$$

wobei $\varepsilon_0$ die dielektrische Konstante im Vakuum, $\varepsilon_r$ die dielektrische Konstante des Mediums zwischen Membran und Elektrodenschicht, x die momentane Auslenkung der Membran, $x_G$ der Abstand zwischen Membran und Elektrodenschicht, t die Zeit, U die zwischen Membran und Elektrodenschicht anliegende Spannung, m die Masse der Membran und A die planparallele Fläche von Membran und Elektrodenschicht sind.

Im Falle einer federnd aufgehängten Membran muss zusätzlich noch gegen die mit der Auslenkung immer größer werdende Federkraft kx, mit k als Federkonstante, beschleunigt werden, so dass die Beschleunigung a um den Betrag von kx verringert wird. Die Beschleunigung a ist daher immer dann besonders hoch, wenn die retardierenden Kräfte, beispielsweise die Federkraft kx oder die Dämpfung der Membran, besonders groß werden.

Wenn die Elektrodenschicht bzw. die Membranschicht zusätzliche Vertiefungen aufweist, das heißt, Abschnitte, in denen die Membranschicht bei einer vertikalen Bewegung der Membran gegenüber der Elektrodenschicht lateral verschoben wird, ergibt sich für die elektrostatische Kraft F auf einen vertikal gegenüber feststehenden Elektrodenschichtabschnitten bewegten Membranschichtabschnitt

$$F = \frac{1}{2} \cdot \frac{dC_y}{dx} \cdot U^2 = \frac{\varepsilon_0 \cdot \varepsilon_r \cdot L_y}{2 \cdot y_G{}^2},$$

wobei $C_y$ der Wert der Kapazität zwischen vertikalen Membranschichtabschnitten und vertikalen Elektrodenschichtabschnitten, $y_G$ der Abstand zwischen vertikalen Membranschichtabschnitten und vertikalen Elektrodenschichtabschnitten und $L_y$ die Länge aller vertikalen Membranschichtabschnitte sind. Die vertikalen Membranschichtabschnitte können dabei die Abschnitte 2b in den Fig. 1, 2, 4 und 5 sein. Die vertikalen Elektrodenschichtabschnitte können dabei die Abschnitte 1b in den Fig. 1 bis 5 sein.

Mit dieser zusätzlichen retardierenden Kraft ergibt sich eine Gesamtbewegungsgleichung für Membrananordnungen mit verschachtelten Vertiefungen, wie beispielsweise für die in den Fig. 1 bis 5 gezeigten Membrananordnungen 100, 200, 300, 400, 500:

$$a = \frac{d^2x}{dt^2} = \frac{\varepsilon_0 \cdot \varepsilon_r \cdot U^2}{2 \cdot \rho \cdot d \cdot (A + x_k \cdot L_y)} \cdot \left( \frac{A}{(x - x_G)^2} + \frac{L_y}{y_G} \right),$$

wobei $\rho$ die Dichte des Membranschichtmaterials, $d$ die Dicke der Membranschicht und $x_k$ die Tiefe bzw. vertikale Erstreckung der Vertiefungen sind. Damit kann über die vertikalen Vertiefungsabschnitte bzw. deren geometrische Abmessungen ein einstellbarer Beschleunigungsterm geschaffen werden, der hohe Beschleunigungen auch aus der Ruhelage der Membran zulässt.

Mit den vorliegenden Membrananordnungen 100, 200, 300, 400, 500, wie in den Fig. 1 bis 8 dargestellt, ist im Gegenzug bei sensierenden Membranen, zum Beispiel bei einem Mikrofon, oder bei einem akustischen Drucksensor, durch eine Beschleunigung der Membran aus der Ruhelage heraus vorteilhafterweise ein großer Signalhub möglich. Dadurch kann ein die Membranordnung verwendender MEMS-Sensor effizient und mit hoher Messempfindlichkeit betrieben werden.

Die Messkapazität $C_x$ zwischen einer planaren Membran und einer planparallel dazu angeordneten Elektrodenschicht beträgt

$$C_x = \frac{\varepsilon_0 \cdot \varepsilon_r \cdot A}{(x - x_G)}.$$

Eine Änderung des vertikalen Abstands $x$ zwischen Membran und Elektrodenschicht führt zu einer Kapazitätsänderung von

$$\frac{dC_x}{dx} = \frac{\varepsilon_0 \cdot \varepsilon_r \cdot A}{(x - x_G)^2} \Rightarrow \frac{dC_x}{C_x} = \frac{dx}{(x - x_G)},$$

das heißt, die Kapazitätsänderung ist für kleine Auslenkungen relativ klein. Für eine Membranschicht bzw. eine Elektrodenschicht mit Vertiefungen, wie im Zusammenhang mit den Membrananordnungen 100, 200, 300, 400, 500 der Fig. 1 bis 5 erläutert, ergibt sich eine Messkapazität $C_G$ von

$$C_G = \frac{\varepsilon_0 \cdot \varepsilon_r \cdot A}{(x - x_G)} + \frac{\varepsilon_0 \cdot \varepsilon_r \cdot (x_k + x) \cdot L_y}{y_G}.$$

Demzufolge beträgt die Kapazitätsänderung einer derartigen Messkapazität $C_G$:

$$\frac{dC_G}{dx} = \frac{\varepsilon_0 \cdot \varepsilon_r \cdot A}{(x - x_G)^2} + \frac{\varepsilon_0 \cdot \varepsilon_r \cdot L_y}{y_G} \Rightarrow \frac{dC_G}{C_G} = \frac{\left( \frac{A}{(x - x_G)^2} + \frac{L_y}{y_G} \right) \cdot dx}{\left( \frac{A}{(x - x_G)} + \frac{(x_k + x) \cdot L_y}{y_G} \right)}.$$

Gegenüber planparallelen Membranen und Elektrodenschichten ergibt sich somit ein verbesserter Signalhub auch bei kleinen Auslenkungen bzw. bei großen vertikalen Abstandswerten. Insbesondere kann über die Geometrie der Vertiefungen der Signalhub eingestellt werden.

Zur Vermeidung parasitärer Kapazitäten kann, wie beispielsweise für die Membrananordnungen 200 oder 500 in den Fig. 2 und 5 dargestellt, der vertikale Abstand $x_G$ zwischen Membranschicht 2 und Elektrodenschichten 1 bzw. 3 genauso groß gewählt werden wie die vertikale Erstreckung $x_k$ der Vertiefungen 2a und 1a bzw. 3a. Damit ist in der Ruhelage der Membranschicht 2 der vertikale Kapazitätsanteil im Wesentlichen Null. Gleichzeitig führt aber eine geringe Auslenkung zum Entstehen eines Überlapps bzw. einer Verzahnung zwischen den Vertiefungen 2a und 1a bzw. 3a, was einen nicht verschwindenden vertikalen Kapazitätsanteil hervorruft.

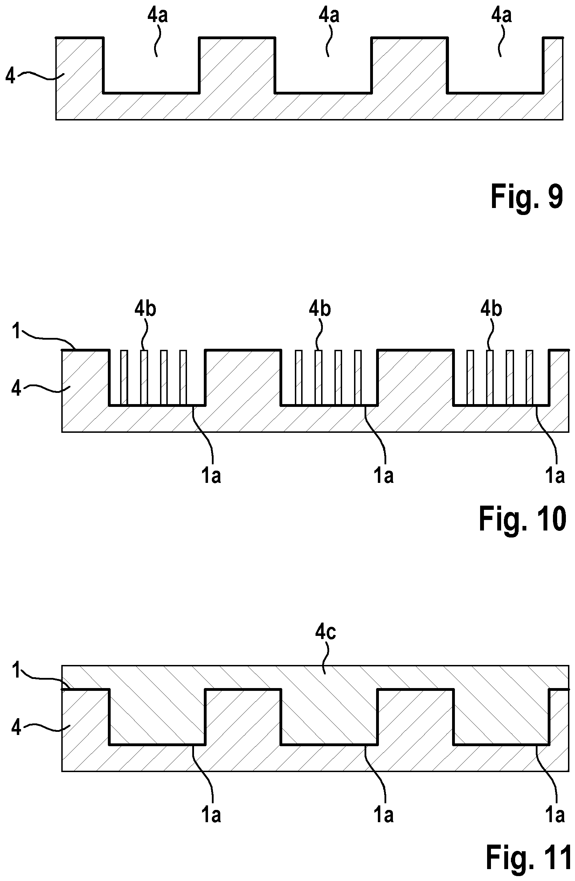

Die Fig. 9 bis 13 zeigen Prozessstufen eines Verfahrens zum Herstellen einer Membrananordnung, welches nicht unter die Erfindung fällt. Das Verfahren kann beispielsweise dazu eingesetzt werden, um eine Membrananordnung 100, 200, 300, 400, 500 herzustellen, wie in den Fig. 1 bis 8 gezeigt.

Zunächst werden in einem Substrat 4, beispielsweise einem SOI-Wafer, Ausnehmungen 4a hergestellt. In diese Ausnehmungen 4a und über die Oberfläche des Substrats 4 kann eine erste elektrisch leitfähige Elektrodenschicht 1 eingebracht werden, wobei die Elektrodenschicht 1 eine Vielzahl von mit den Ausnehmungen 4a übereinstimmende erste Vertiefungen 1a aufweist. In den Ausnehmungen 4a können weiterhin Opferstege 4b ausgebildet werden, beispielsweise durch das Erzeugen von Trenchgräben in den Ausnehmungen 4a. Die Opferstege 4b können dazu als Oxidationspunkte für das Ausbilden einer Oxidschicht 4c dienen. Die Oxidschicht in Fig. 11 füllt die Ausnehmungen 4a vollständig aus und bedeckt die Oberfläche des Substrats 4. Gegebenenfalls kann ein chemisch-mechanischer Bearbeitungsschritt (CMP) zur Planarisierung und Verdünnung der Oxidschicht 4c erfolgen. Dann kann die Oxidschicht 4c selektiv in den Ausnehmungen 4a beispielsweise über einen Lithographieschritt geätzt werden.

Danach wird eine elektrisch leitfähige Membranschicht 2 auf der Oxidschicht 4c abgeschieden. Die elektrisch leitfähige Membranschicht 2 kann beispielsweise durch Deposition von Polysilizium ausgebildet werden. Dabei kann die Membranschicht 2 über mit den Ausnehmungen 4a übereinstimmende Vertiefungen 2a verfügen. In dem Substrat 4 und der ersten elektrisch leitfähigen Elektrodenschicht 1 können erste Durchgangslöchern 5a ausgebildet werden, durch die die Oxidschicht 4c geätzt werden kann. Dadurch wird die elektrisch leitfähige Membranschicht 2 freigestellt, so dass die Membranschicht 2 gegenüber der ersten Elektrodenschicht 1 auslenkbar und von dieser um einen ersten Abstandswert $x_G$ beabstandet ist. Optional können auch in der Membranschicht 2 Durchgangslöcher 5d ausgebildet werden.

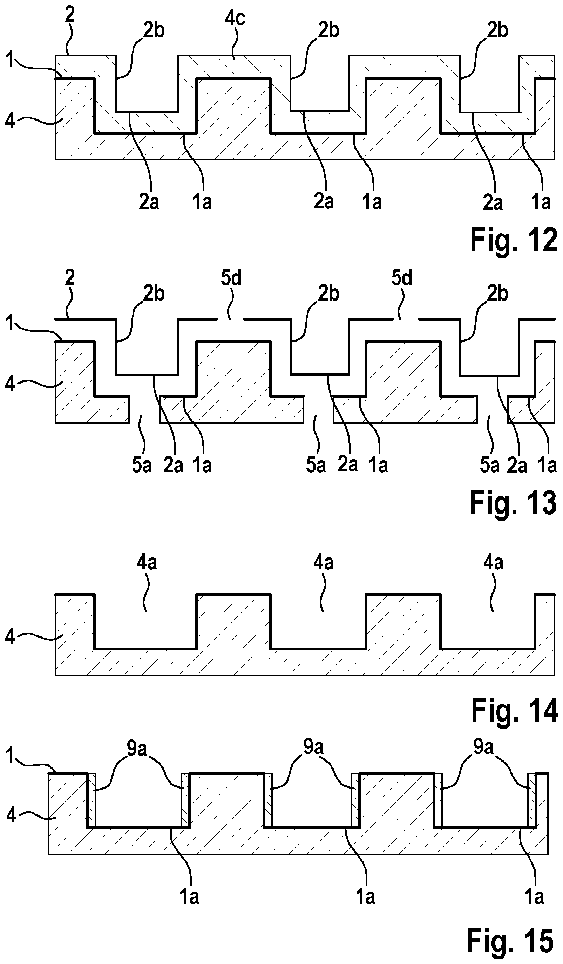

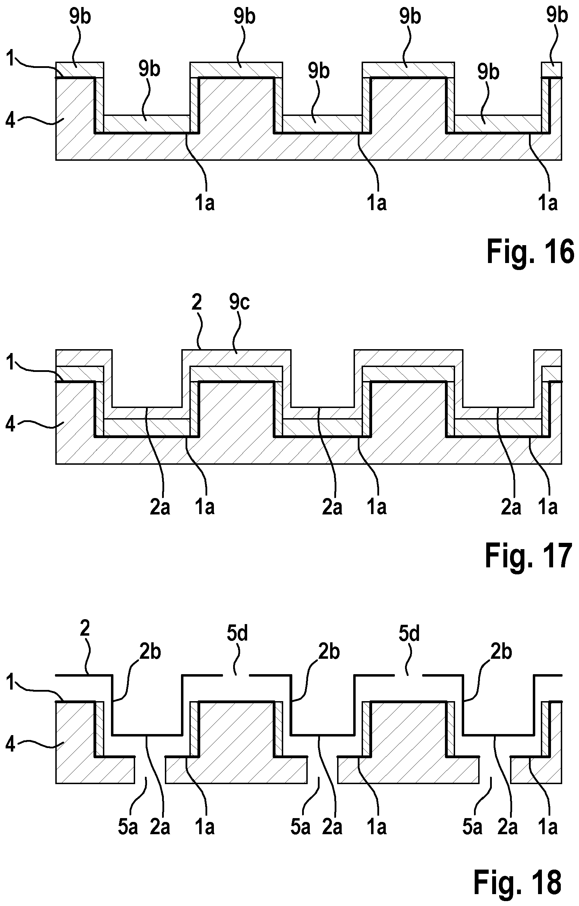

Die Fig. 14 bis 18 zeigen Prozessstufen eines weiteren Verfahrens zum Herstellen einer Membrananordnung, welches nicht unter die Erfindung fällt. Das Verfahren kann beispielsweise dazu eingesetzt werden, um eine Membrananordnung 100, 200, 300, 400, 500 herzustellen, wie in den Fig. 1 bis 8 gezeigt.

Ähnlich wie in Fig. 9 gezeigt werden zunächst Ausnehmungen 4a in einem Substrat 4 ausgebildet, über denen eine Elektrodenschicht 1 ausgebildet wird. Über einen Abscheidungsprozess und anschließenden gerichteten Ätzprozess können beispielsweise vertikal an den Außenwänden der Ausnehmungen 1a angeordnete Nitridstreifen ausgebildet werden. Eine Oxidschicht 9b, beispielsweise eine LOCOS-Oxid, kann über der Oberfläche des Substrats 4 und den Ausnehmungen 4 gebildet werden. In einem weiteren Abscheidungsprozess können beispielsweise TEOS-Oxidschichten 9c über den Oxidschichten 9b und der Nitridschicht 9a ausgebildet werden. Über den TEOS-Oxidschichten 9c kann dann eine Membranschicht 2, beispielsweise aus Polysilizium abgeschieden werden.

Wiederum kann dann ein Ausbilden von ersten Durchgangslöchern 5a in dem Substrat 4 und der ersten elektrisch leitfähigen Elektrodenschicht 1 erfolgen, durch die die Oxidschichten 9b und 9c geätzt werden können. Dadurch wird die elektrisch leitfähige Membranschicht 2 freigestellt, so dass die Membranschicht 2 gegenüber der ersten Elektrodenschicht 1 auslenkbar und von dieser um einen ersten Abstandswert $x_G$ beabstandet ist. Optional können auch in der Membranschicht 2 Durchgangslöcher 5d ausgebildet werden.

Zur Verhinderung von Distorsionen in den Außenwänden 2b bzw. 1b der Vertiefungen 2a bzw. 1a können beispielsweise Biegeradien an den Stoßlinien der vertikal zueinander stehenden Schichtabschnitte verrundet werden, beispielsweise über isotrope Ätzschritte oder Vakuumannealmaßnahmen. Ähnliche Maßnahmen können auch zur Verbesserung der Abstrahlimpedanz bei den Durchgangslöchern 5a bis 5d erfolgen.

**Patentansprüche**

1. Mikro-elektromechanische Membrananordnung (100; 200), mit:

    einem Substrat (4), welches auf einer Oberfläche eine Vielzahl von Ausnehmungen (4a) aufweist;
    einer ersten elektrisch leitfähigen Elektrodenschicht (1), welche auf der Oberfläche des Substrats (4) angeordnet ist und welche eine Vielzahl von mit den Ausnehmungen (4a) des Substrats (4) übereinstimmende erste Vertiefungen (1a) aufweist; und
    einer in einer Richtung senkrecht zu der Oberfläche des Substrats (4) auslenkbaren und elektrisch leitfähigen Membranschicht (2; 7), welche über der ersten Elektrodenschicht (1) angeordnet und von dieser um einen ersten Abstandwert ($x_G$) beabstandet ist;

wobei die Membranschicht (2) eine Vielzahl von über den ersten Vertiefungen (1a) ausgebildeten zweiten Vertiefungen (2a) aufweist;

und wobei die zweiten Vertiefungen (2a) dazu ausgelegt sind, bei einer Auslenkung der Membranschicht (2) senkrecht zu der Oberfläche des Substrats (4) berührungslos in die ersten Vertiefungen (1a) ineinander zu greifen;

**gekennzeichnet durch**

eine zweite elektrisch leitfähige Elektrodenschicht (3), welche über der Membranschicht (2; 7) angeordnet ist, und welche eine Vielzahl von über den ersten Vertiefungen (1a) ausgebildeten dritten Vertiefungen (3a) aufweist, wobei die ersten Vertiefungen (1a), die zweiten Vertiefungen (2a) und die dritten Vertiefungen (3a) so zueinander ausgebildet sind, dass bei der Auslenkung der Membranschicht (2) senkrecht zu der Oberfläche des Substrats (4) die zweiten Vertiefungen (2a) berührungslos in die ersten Vertiefungen (1a) und die dritten Vertiefungen (3a) berührungslos in die zweiten Vertiefungen (2a) ineinander greifen.

2. Membrananordnung (100) nach Anspruch 1, wobei die zweiten Vertiefungen (2a) Außenwände (2b) mit einer vertikalen Erstreckung aufweisen, die größer als der erste Abstandswert ($x_G$) ist.

3. Membrananordnung (200) nach Anspruch 1, wobei die zweiten Vertiefungen (2a) Außenwände (2b) mit einer vertikalen Erstreckung aufweisen, die genauso groß wie der erste Abstandswert ($x_G$) ist.

4. Membrananordnung (200) nach einem der vorhergehenden Ansprüche, wobei die Außenwände der ersten Vertiefungen (1a) von den Außenwänden (2b) der zweiten Vertiefungen (2a) parallel zu der Oberfläche des Substrats (4) einen zweiten Abstandswert ($y_G$) aufweisen.

5. Membrananordnung (100; 200) nach einem der vorhergehenden Ansprüche, wobei die Außenwände (2b) der zweiten Vertiefungen (2a) von den Außenwänden der dritten Vertiefungen (3a) parallel zu der Oberfläche des Substrats (4) den zweiten Abstandswert ($y_G$) aufweisen.

6. Membrananordnung (100; 200) nach einem der vorhergehenden Ansprüche, wobei die erste Elektrodenschicht (1) und das Substrat (4) eine Vielzahl von ersten Druckausgleichslöchern (5a) aufweisen, welche in den ersten Vertiefungen (1a) ausgebildet sind.

7. Membrananordnung (100; 200) nach einem der vorhergehenden Ansprüche, wobei die erste Elektrodenschicht (1) vom Substrat (4) gebildet wird.

8. Membrananordnung (100; 200) nach einem der vorhergehenden Ansprüche, wobei die zweite Elektrodenschicht (3) eine Vielzahl von dritten Druckausgleichslöchern (5b; 5c) aufweisen, welche in den dritten Vertiefungen (3a) und/oder zwischen den dritten Vertiefungen (3a) ausgebildet sind.

9. Mikro-elektromechanisches Bauelement, mit einer mikro-elektromechanischen Membrananordnung (100; 200) nach einem der vorhergehenden Ansprüche.

10. Mikro-elektromechanisches Bauelement nach Anspruch 9, wobei das mikro-elektromechanische Bauelement ein Drucksensor, ein Mikrofon oder ein Lautsprecher ist.

**Claims**

1. Microelectromechanical membrane arrangement (100; 200) comprising:

a substrate (4) which has a multiplicity of cutouts (4a) in a surface;
a first electrically conductive electrode layer (1), which is arranged on the surface of the substrate (4) and which has a multiplicity of first depressions (1a) corresponding to the cutouts (4a) of the substrate (4); and
an electrically conductive membrane layer (2; 7), which can be deflected in a direction perpendicular to the surface of the substrate (4), is arranged over the first electrode layer (1) and is spaced apart from said first electrode layer by a first distance value ($x_G$);
wherein the membrane layer (2) has a multiplicity of second depressions (2a) formed over the first depressions (1a);

and wherein the second depressions (2a) are configured so as to engage in the first depressions (1a) one inside the other without any touching contact when the membrane layer (2) is deflected perpendicular to the surface of the substrate (4);

**characterized by**

a second electrically conductive electrode layer (3), which is arranged over the membrane layer (2; 7), and which has a multiplicity of third depressions (3a) formed over the first depressions (1a),

wherein the first depressions (1a), the second depressions (2a) and the third depressions (3a) are formed in relation to one another such that the second depressions (2a) engage in the first depressions (1a) one inside the other without any touching contact and the third depressions (3a) engage in the second depressions (2a) one inside the other without any touching contact when the membrane layer (2) is deflected perpendicular to the surface of the substrate (4).

2.  Membrane arrangement (100) according to Claim 1, wherein the second depressions (2a) have outer walls (2b) having a vertical extent which is greater than the first distance value ($x_G$).

3.  Membrane arrangement (200) according to Claim 1, wherein the second depressions (2a) have outer walls (2b) with a vertical extent which is precisely the same size as the first distance value ($x_G$).

4.  Membrane arrangement (200) according to one of the preceding claims, wherein the outer walls of the first depressions (1a) have a second distance value ($y_G$) from the outer walls (2b) of the second depressions (2a) parallel to the surface of the substrate (4).

5.  Membrane arrangement (100; 200) according to one of the preceding claims, wherein the outer walls (2b) of the second depressions (2a) have the second distance value ($y_G$) from the outer walls of the third depressions (3a) parallel to the surface of the substrate (4).

6.  Membrane arrangement (100; 200) according to one of the preceding claims, wherein the first electrode layer (1) and the substrate (4) have a multiplicity of first pressure compensation holes (5a), which are formed in the first depressions (1a).

7.  Membrane arrangement (100; 200) according to one of the preceding claims, wherein the first electrode layer (1) is formed by the substrate (4).

8.  Membrane arrangement (100; 200) according to one of the preceding claims, wherein the second electrode layer (3) has a multiplicity of third pressure compensation holes (5b; 5c), which are formed in the third depressions (3a) and/or between the third depressions (3a).

9.  Microelectromechanical component, comprising a microelectromechanical membrane arrangement (100; 200) according to one of the preceding claims.

10. Microelectromechanical component according to Claim 9, wherein the microelectromechanical component is a pressure sensor, a microphone or a loudspeaker.


**Revendications**

1.  Système de membrane microélectromécanique (100 ; 200), emportant :

    un substrat (4) qui présente une pluralité d'évidements (4a) sur une surface ;
    une première couche d'électrode électriquement conductrice (1) qui est disposée sur la surface du substrat (4) et qui présente une pluralité de premiers renfoncements (1a) correspondant aux évidements (4a) du substrat (4) ; et
    une couche de membrane électriquement conductrice (2 ; 7) pouvant être écartée dans une direction perpendiculaire à la surface du substrat (4), qui est disposée au-dessus de la première couche d'électrode (1) et en est espacée d'une première valeur d'espacement ($x_G$) ;
    dans lequel la couche de membrane (2) présente une pluralité de deuxièmes renfoncements (2a) formés au-dessus des premiers renfoncements (1a) ;

et dans lequel les deuxièmes renfoncements (2a) sont conçus pour s'engager sans contact dans les premiers renfoncements (1a) lors d'un écartement de la couche de membrane (2) perpendiculairement à la surface du substrat (4) ;

**caractérisé par**

une deuxième couche d'électrode électriquement conductrice (3) qui est disposée au-dessus de la couche de membrane (2 ; 7) et qui présente une pluralité de troisièmes renfoncements (3a) formés au-dessus des premiers renfoncements (1a),

dans lequel les premiers renfoncements (1a), les deuxièmes renfoncements (2a) et les troisièmes renfoncements (3a) sont réalisés les uns par rapport aux autres de manière à ce que les deuxièmes renfoncements (2a) s'engagent sans contact dans les premiers renfoncements (1a) et à ce que les troisièmes renfoncements (3a) s'engagent sans contact dans les deuxièmes renfoncements (2a) lors de l'écartement de la couche de membrane (2) perpendiculairement à la surface du substrat (4).

2. Système de membrane (100) selon la revendication 1, dans lequel les deuxièmes renfoncements (2a) présentent des parois extérieures (2b) ayant une extension verticale qui est supérieure à la première valeur d'espacement ($x_G$).

3. Système de membrane (200) selon la revendication 1, dans lequel les deuxièmes renfoncements (2a) présentent des parois extérieures (2b) ayant une extension verticale qui est égale à la première valeur d'espacement ($x_G$).

4. Système de membrane (200) selon l'une quelconque des revendications précédentes, dans lequel les parois extérieures des premiers renfoncements (1a) présentent une deuxième valeur d'espacement ($y_G$) par rapport aux parois extérieures (2b) des deuxièmes renfoncements (2a) parallèlement à la surface du substrat (4).

5. Système de membrane (100 ; 200) selon l'une quelconque des revendications précédentes, dans lequel les parois extérieures (2b) des deuxièmes renfoncements (2a) présentent la deuxième valeur d'espacement ($y_G$) par rapport aux parois extérieures des troisièmes renfoncements (3a) parallèlement à la surface du substrat (4).

6. Système de membrane (100 ; 200) selon l'une quelconque des revendications précédentes, dans lequel la première couche d'électrode (1) et le substrat (4) présentent une pluralité d'orifices d'égalisation de pression (5a) qui sont formés dans les premiers renfoncements (1a).

7. Système de membrane (100 ; 200) selon l'une quelconque des revendications précédentes, dans lequel la première couche d'électrode (1) est formée par le substrat (4).

8. Système de membrane (100 ; 200) selon l'une quelconque des revendications précédentes, dans lequel la deuxième couche d'électrode (3) présente une pluralité de troisièmes orifices d'égalisation de pression (5b ; 5c) qui sont formés dans les troisièmes renfoncements (3a) et/ou entre les troisièmes renfoncements (3a).

9. Composant microélectromécanique comportant un système de membrane microélectromécanique (100 ; 200) selon l'une quelconque des revendications précédentes.

10. Composant microélectromécanique selon la revendication 9, dans lequel le composant microélectromécanique est un capteur de pression, un microphone ou un haut-parleur.

**Fig. 1**

**Fig. 2**

**Fig. 3**

400

2
1
1b
4
2U  2b    2D  5d    x_G    5d    2b

y_G  2a  5a  1a    2a  5a  1a  6a    2a  5a  1a    1b

**Fig. 4**

500

2
1
1b
4
2U    2b    5d  2D    x_G    5d    2b

y_G  2a  5a  1a    2a  5a  1a  6a    2a  5a  1a    1b

**Fig. 5**

Fig. 6

Fig. 7

Fig. 8

4a    4a    4a

4

Fig. 9

1
4b    4b    4b

4

1a    1a    1a

Fig. 10

4c

1

4

1a    1a    1a

Fig. 11

Fig. 12

Fig. 13

Fig. 14

Fig. 15

Fig. 16

Fig. 17

Fig. 18

**EP 2 836 455 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10247847 A1
- DE 102006055147 B4
- EP 2071871 A1
- US 6035714 A
- US 6441451 B1
- JP 2008259061 A

**In der Beschreibung aufgeführte Nicht-Patentliteratur**

- On the single-chip condenser miniatur microphone using DRIE and backside etching techniques. SENSORS AND ACTUATORS A. ELSEVIER SEQUOIA S.A, 15. Januar 2003, vol. 103, 42-47